# EUROPÄISCHE PATENTSCHRIFT

(11) **EP 0 845 107 B1**
(45) Veröffentlichungstag und Bekanntmachung des Hinweises auf die Patenterteilung: **24.03.1999**
(21) Anmeldenummer: 96928344.9
(22) Anmeldetag: 05.08.1996
(51) Int. Cl.: G01R 31/327

(54) **MESSSYSTEM FÜR ELEKTRISCHE STÖRUNGEN IN EINER HOCHSPANNUNGSSCHALTANLAGE**
MEASUREMENT SYSTEM FOR ELECTRIC DISTURBANCES IN A HIGH-VOLTAGE SWITCHBOARD PLANT
SYSTEME POUR MESURER DES INTERFERENCES ELECTRIQUES DANS UNE INSTALLATION DE DISTRIBUTION ELECTRIQUE H.T.

(30) Priorität: 15.08.1995 DE 19531827
(43) Veröffentlichungstag der Anmeldung: 03.06.1998
(73) Patentinhaber: SIEMENS AKTIENGESELLSCHAFT, 80333 München (DE)
(72) Erfinder: ACHATZ, Norbert, D-12163 Berlin (DE)
(86) Internationale Anmeldenummer: DE9601482
(87) Internationale Veröffentlichungsnummer: WO9707411

(56) Entgegenhaltungen:
- EP-A- 0 488 719
- WO-A-92/06385
- DE-A- 4 310 619
- US-A- 5 223 795

## Beschreibung

Die Erfindung bezieht sich auf ein Meßsystem für elektrische Störungen in einer gekapselten Hochspannungsschaltanlage, die eine Nutzspannung in Form einer niederfrequenten Wechselspannung führt mit jeweils wenigstens einer Meßsonde für jede Phase zur Auskopplung elektromagnetischer Störsignale aus der Schaltanlage und mit einer Auswerteinrichtung zur Ermittlung der zeitlichen Zuordnung des Auftretens der Störsignale in bezug auf die Periode der niederfrequenten Nutzspannung der jeweiligen Phase, bei der die Störsignale auftreten, wobei zu wenigstens einer Phase sowohl die Störsignale als auch die Nutzspannung jeweils durch dieselbe, als Meßelektrode ohne galvanische Ankopplung ausgebildete Meßsonde abgegriffen werden.

Ein derartiges Meßsystem ist beispielsweise aus dem Prospekt Diagnostic Monitoring Systems"/University of Strathclyde, Scottish Power sowie aus der EP 0 488 719 A2 bekannt.

Bei dem dort beschriebenen Meßsystem werden Störsignale mittels Meßsonden ausgekoppelt und analysiert.

Um die relative Phasenlage der Störsignale in bezug auf die Nutzspannung festzustellen, wird an der jeweiligen Phase, auf der ein Störsignal aufgetreten ist, die Nutzspannung abgegriffen und ein der Nutzspannung proportionales Signal an das Meßsystem geleitet.

Es muß dann bei Untersuchungen von Störungen an den verschiedenen Phasen jeweils die entsprechende Phase zur Ermittlung des Nutzspannungssignals ausgewählt werden, um die Phasenlage des Störsignals festzustellen.

Bei der Zuordnung der Phasen zu den Störsignalen können leicht Fehler auftreten, so daß einem Störsignal eine falsche Phasenlage zugeordnet wird.

Gemäß der DE 43 10 619 A1 wird ein Störsignal im Hochfrequenzbereich mittels Resonanzkreisen und bekannten Teilentladungsmeßeinheiten aufgenommen, dies wird jedoch nicht zu einem Nutzsignal (beispielsweise 50 Hz Versorgungsspannung) in Beziehung gesetzt. Es werden dort lediglich Hochfrequenz-signale in unterschiedlichen Frequenzbereichen erfaßt.

Die US 5,223,795 befaßt sich mit einem Verfahren, bei dem ein Ausbleiben hochfrequenter Signalanteile bezogen auf eine Grundfrequenz (Nutzfrequenz) erfaßt wird. Zur Überwachung der hochfrequenten Signalanteile der Spannung ist der Phasenleiter sowohl mit einer Hochfrequenzanalyseeinrichtung als auch mit einer Einrichtung zur Analyse der Grundfrequenz galvanisch verbunden oder mittels eines Stromwandlers gekoppelt.

Auch aus der DE 69 100 721 T2 ist eine Anordnung zur Detektion leitungsgebundener Störsignale, dort im Zusammenhang mit elektrischen Maschinen, bekannt. Die Detektion findet ausschließlich durch kapazitive Ankopplung der Meßeinrichtung an das System statt.

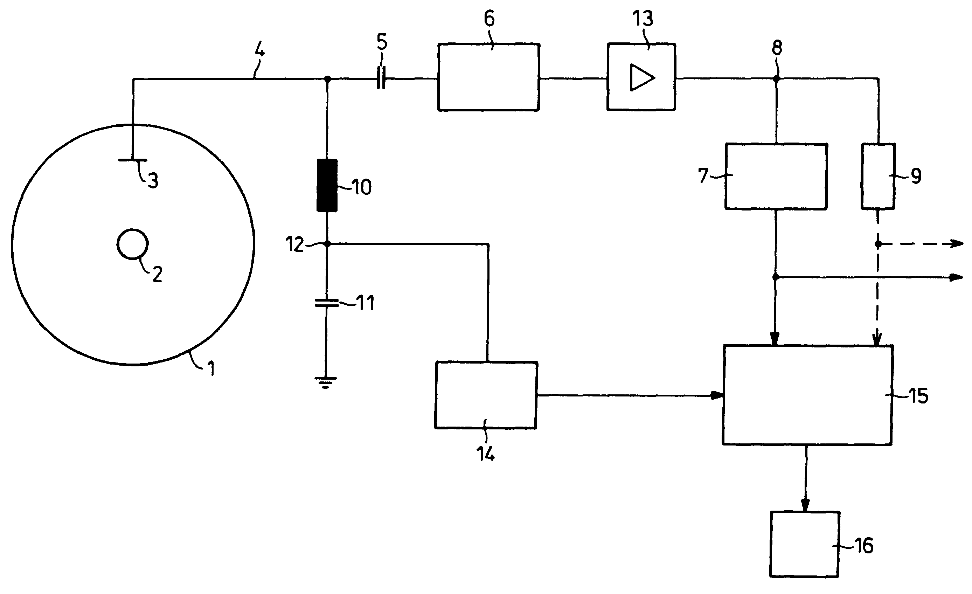

Aus der US 5,396,180 ist ein Detektionssystem für Signale in einer Hochspannungsschaltanlage bekannt, bei der die Signale im UHF-Bereich durch einen Betrieb einer Meßelektrode als Antenne gewonnen werden, jedoch die Informationen über den zeitlichen Verlauf der Netzfrequenz (vgl. dort Figur 5, rechts oben) offenbar aus einer hiervon getrennten, gesonderten Vorrichtung gewonnen werden.

Der vorliegenden Erfindung liegt die Aufgabe zugrunde, bei einem Meßsystem der eingangs genannten Art auf möglichst einfache Weise ein der Nutzspannung entsprechendes Signal zur Verfügung zu stellen, das einem Störsignal auf einer bestimmten Phase zugeordnet werden kann.

Die Aufgabe wird erfindungsgemäß dadurch gelöst, daß die Störsignale und die Nutzspannung an einer Filteranordnung, welche gleichzeitig einerseits durch eine erste Beschaltung einen Antennenbetrieb für elektromagnetische Strahlung im Hochfrequenzbereich zwischen etwa 300 Mhz und 3 GHz, andererseits durch eine zweite Beschaltung einen kapazitiven Spannungsteilerbetrieb im niederfrequenten Bereich bewirkt, getrennt voneinander zugänglich sind.

Durch die erfindungsgemäße Konstruktion ist gewährleistet, daß einem auftretenden Störsignal jeweils zweifelsfrei die richtige Phase mit dem richtigen Nutzspannungssignal zugeordnet wird und daß entsprechend auch die relative Phasenlage zuverlässig bestimmt werden kann.

Sollen verschiedene Meßsonden nacheinander abgefragt werden, so wird durch die Erfindung erreicht, daß die jeweils von einer Meßsonde erfaßten Signale automatisch dem Nutzspannungssignal der entsprechenden Phase richtig zugeordnet werden.

Außerdem werden eine gesonderte Einrichtung zum separaten Abnehmen des Nutzsignals aus der Hochspannungsschaltanlage oder gesonderte Meßsonden zum Auskoppeln des Nutzspannungssignals eingespart.

Die vorliegende Erfindung beruht darauf, daß ein und dieselbe Meßsonde ohne eine galvanische Ankopplung an einen Hochspannungsleiter die Bereitstellung von Informationen sowohl über hochfrequente Störsignale als auch über die niederfrequente Nutzwechselspannung ermöglicht.

Für die hochfrequenten Signalanteile bildet die Meßelektrode, wie aus der US- 5 223 795 bekannt, eine Antenne zum Empfang elektromagnetischer Strahlung. Die Ankopplung an den Innenraum der Kapselung der Hochspannungsschaltanlage ist für diesen Frequenzbereich (ca. 300 Mhz-3 GHz) nicht rein kapazitiv.

Die Information über den zeitlichen Verlauf der Nutzspannung wird durch die in der Hochspannungsmeßtechnik übliche, rein kapazitive Ankopplung der Meßelektrode an einen Hochspannungsleiter erreicht, trotz niederohmiger Ankopplung für die hochfrequenten Störsignale. Dies wird durch die sich einstellende Spannungsteilung der Hochspannung an dem zwischen dem Hochspannungsleiter und der Meßelektrode gebildeten Hochspannungskondensator gegenüber dem zwischen der über eine Spule an der Meßelektrode und dem Erdpotential angeschlossenen Niederspannungskondensator erreicht.

Für die erforderliche Empfindlichkeit der im Antennenbetrieb empfangenen hochfrequenten Meßsignale (Störsignale) kann eine in der HF-Technik übliche und vorteilhafte 50 Ω-Meß- und Verstärkertechnik eingesetzt werden.

Diese zwei unterschiedlichen Signaltypen fallen somit an unterschiedlichen Lastwiderständen ab, für den "Antennenbetrieb" niederohmig, bevorzugt 50 Ω und den "Spannungsteilerbetrieb" hochohmig, bevorzugt ≥ 1 MΩ.

Die Eigenschaft einer solchen Meßsonde, zwei unterschiedliche Arten von Informationen in unterschiedlichen Frequenzbereichen mittels unterschiedlicher Funktionsprinzipien zu erfassen, ermöglicht einen einfachen, kostengünstigen und zuverlässigen Aufbau des Meßsystems.

Außerdem kann es vorteilhaft vorgesehen sein, daß zusätzliche Filteranordnungen die Abnahme von Störsignalen in mehreren verschiedenen Frequenzbereichen ermöglichen.

Durch diese Ausgestaltung wird es möglich, die Störsignale in verschiedenen Frequenzbereichen zu analysieren. Dies ist insbesondere deshalb vorteilhaft, da verschiedene in einer Schaltanlage auftretende Störungen in unterschiedlichen Isolierstoffen Störsignale in unterschiedlichen Freqenzbereichen verbreiten, so daß von der Verteilung der Freqenzanteile von Störsignalen auf die Art der vorliegenden Störung geschlossen werden kann.

Eine vorteilhafte Ausgestaltung der Erfindung sieht vor, daß jeweils an eine Meßsonde mittels einer Meßleitung ein Kondensator angeschlossen ist, an dem die hochfrequenten Störsignale abnehmbar sind, daß die Meßleitung zwischen der Meßsonde und dem Kondensator über einen Tiefpaß mit dem Erdpotential verbunden ist und daß sowohl der Kondensator als auch der Ausgang des Tiefpasses mit einer Auswerteinrichtung zur Auswertung der relativen Phasenlage der Störsignale zur Nutzspannung verbunden sind.

Der Kondensator bildet zusammen mit dem Tiefpaß eine Filteranordnung, wobei an dem Kondensator die hochfrequenten Signalanteile und an dem Tiefpaß die niederfrequenten Signalanteile abnehmbar sind. Der Pfad für die hochfrequenten Signalanteile wird vorteilhaft für Frequenzen bis zu 3 GHZ ausgelegt.

Der Tiefpaß kann beispielsweise unter Verwendung einer Spule realisiert sein, die zu einem weiteren Kondensator in Reihe geschaltet ist.

Die in der Filteranordnung verwendeten kapazitiven und induktiven Elemente sind vorteilhaft so aufeinander abgestimmt, daß eine möglichst minimale Phasenverschiebung des Nutzspannungssignals bewirkt wird.

Besonders vorteilhaft kann es vorgesehen sein, daß dem Kondensator eine weitere Filteranordnung nachgeschaltet ist, die die Abnahme von Störsignalen in mehreren verschiedenen Frequenzbereichen ermöglicht.

Durch diese Ausgestaltung wird es möglich, die hochfrequenten Störsignale in verschiedenen Frequenzbereichen zu analysieren.

Eine weitere vorteilhafte Ausgestaltung der Erfindung sieht vor, daß an dem Tiefpaß zusätzlich zu dem Nutzspannungssignal eingekoppelte höherfrequente Signalanteile von transienten Überspannungen mit gedämpfter Intensität abnehmbar sind.

Das Vorhandensein höherfrequenter Signalanteile von transienten Überspannungen zusätzlich zu dem Nutzspannungssignal deutet daraufhin, daß in der Hochspannungsschaltanlage soeben ein Schaltvorgang eines Trenn- oder Leistungsschalters stattgefunden hat. Bei solchen Schaltvorgängen treten regelmäßig sowohl transiente Überspannungen als auch Störsignale auf.

Wird bei Vorliegen eines Störsignals ermittelt, daß auch Signalanteile von transienten Überspannungen zusätzlich zu dem Nutzsignal auftreten, so sollten die Störsignale nicht notwendigerweise so interpretiert werden, daß eine Störung vorliegt. Entsprechend kann beispielsweise eine durchgeführte Messung von Störsignalen zu einem späteren Zeitpunkt wiederholt werden.

In diesem Zusammenhang kann es auch vorteilhaft sein, daß die Auswerteinrichtung eine Prüfeinrichtung zur Prüfung des am Ausgang des Tiefpasses anliegenden Signals auf höherfrequente Signalanteile der Nutzspannung oder daraus resultiernde Überspannungen aufweist und daß die Prüfeinrichtung bewirkt, daß im Falle des Vorhandenseins höherfrequenter Signalanteile der Nutzspannung oder daraus resultierender Überspannungen keine Störung ausgewiesen wird.

Im folgenden wird die Erfindung anhand eines Ausführungsbeispiels in einer Zeichnung gezeigt und anschließend beschrieben.

Die Figur zeigt schematisch ein Kapselungsrohr mit einem erfindungsgemäßen Meßsystem für die einzelne Phase.

In dem Kapselungsrohr 1 verläuft konzentrisch ein Hochspannungsleiter 2. Diese beiden Bauteile bilden auch eine Koaxialleitung, auf der sich hochfrequente Störungen ausbreiten können. Der Hochspannungsleiter 2 führt als Nutzspannung eine Wechselspannung mit einer Netzfrequenz von beispielsweise 50 Hz.

In dem Kapselungsrohr 1 ist eine Meßsonde 3 beispielsweise in Form einer von dem Kapselungsrohr 1 isolierten metallischen Meßelektrode angeordnet, die mit einer Meßleitung 4 verbunden ist, welche isoliert durch das Kapselungsgehäuse 1 durchgeführt ist und die Meßsonde 3 mit einer Meßelektronik verbindet. Die Meßelektrode ist somit kapazitiv an den Hochspannungsleiter gekoppelt. An die Meßleitung 4 ist ein erster Kondensator 5 angeschlossen, der einen ersten Hochpaß bildet und hochfrequente Signale zu einer Überspannungsschutzeinrichtung 6 weiterleitet.

Die Überspannungsschutzeinrichtung 6 sorgt dafür, daß empfindliche nachgeschaltete Meßelektronik ausreichend geschützt wird.

Von der Überspannungsschutzreinrichtung 6 werden die hochfrequenten Signale über einen Verstärker 13 an eine Frequenzanalyseeinrichtung 7 weitergeleitet, in der eine genauere Analyse der hochfrequenten Signale, beispielsweise auch eine Fourier-Transformation, und ggf. ein Vergleich mit Referenzmustern stattfindet. Am Anschluß 8, an den die Frequenzanalyseeinrichtung 7 angeschlossen ist, kann auch das unbewertete Störsignal abgegriffen und beispielsweise über einen reflexionsfreien Teiler 9 weiterverarbeitet oder mit 50 Ω abgeschlossen werden.

An der Meßleitung 4 ist außer dem Kondensator 5 eine Induktivität 10, beispielsweise in Form einer Spule angeschlossen, die zusammen mit einem ihr nachgeschalteten Kondensator 11 und der Kapazität der Meßelektrode 3 zum Hochspannungsleiter 2 einen kapazitiven Spannungsteiler bildet. An dem Anschluß 12, der zwischen der Induktivität 10 und dem Kondensator 11 liegt, ist eine Lastimpedanz von einigen Megaohm zulässig. An dem Anschluß 12 sind die niederfrequenten, insbesondere netzfrequenten Signalanteile abnehmbar.

Dort ist eine Einrichtung 14 zur Analyse von niederfrequenten Signalanteilen angeschlossen, die hauptsächlich die netzfrequenten Anteile der von der Meßsonde 3 abgetasteten Signale und ggf. aufgrund ihrer hohen Intensität durchgekoppelte Signalanteile von transienten Überspannungen analysiert.

Die Kondensatoren 5, 11 und die Induktivität 10 inklusive Streukapazität und die Lastimpedanz am Anschluß 12 müssen so aufeinander abgestimmt sein, daß zwischen der Nutzspannung am Leiter 2 und dem an dem Anschluß 12 abgenommenen Nutzspannungssignal keine störende Phasenverschiebung auftritt.

Das Ergebnis der Signalanalyse der hochfrequenten Anteile wird von den Elementen 7 und 9 an eine Auswerteinrichtung 15 abgegeben, der von der Einrichtung 14 das Ergebnis der Analyse der niederfrequenten Signalanteile ebenfalls zugeleitet wird.

Die Auswerteinrichtung 15 bestimmt die relative Phasenlage der hochfrequenten Störsignalanteile zu den netzfrequenten Signalanteilen und stellt den Wert der relativen Phasenlage für eine weitere Analyse und/oder eine Anzeige 16 bereit.

Die Auswerteinrichtung 15 registriert auch beispielsweise das Vorhandensein von Störsignalen von transienten Überspannungen und gibt gegebenenfalls daraufhin ein Signal dergestalt aus, daß die auftretenden hochfrequenten Signale mit hoher Wahrscheinlichkeit durch einen Schaltvorgang in der Schaltanlage hervorgerufen worden sind.

In die Frequenzanalyseeinrichtung 7 kann eine Verarbeitungseinrichtung integriert sein, die den Frequenzbereich der in diesem Zweig der Filteranordnung auftretenden Signale in mehrere Unterfrequenzbereiche unterteilt, die jeweils für sich analysiert werden können. Das Ergebnis der Frequenzanalyse kann sowohl der Auswerteinrichtung 15 als auch einer nicht dargestellten Bewertungseinrichtung zugeleitet werden, die das Ergebnis auch in Abhängigkeit von dem Auswertergebnis der Auswerteinrichtung 15 weiterverarbeitet.

Auf diese Weise können mit einer einzigen Meßsonde 3 für eine Phase einer gekapselten Hochspannungsschaltanlage sowohl ein oder mehrere hochfrequente Signalanteile als auch der zugehörige netzfrequente Signalanteil abgenommen werden.

## Patentansprüche

1. Meßsystem für elektrische Störungen in einer gekapselten Hochspannungsschaltanlage (1, 2), die eine Nutzspannung in Form einer niederfrequenten Wechselspannung führt mit jeweils wenigstens einer Meßsonde (3) für jede Phase zur Auskopplung elektromagnetischer Störsignale aus der Schaltanlage (1, 2) und mit einer Auswerteinrichtung (15) zur Ermittlung der zeitlichen Zuordnung des Auftretens der Störsignale in bezug auf die Periode der niederfrequenten Nutzspannung der jeweiligen Phase, bei der die Störsignale auftreten, wobei zu wenigstens einer Phase sowohl die Störsignale als auch die Nutzspannung jeweils durch dieselbe, als Meßelektrode ohne galvanische Ankopplung ausgebildete Meßsonde (3) abgegriffen werden,
**dadurch gekennzeichnet**, daß
die Störsignale und die Nutzspannung an einer Filteranordnung (5, 10, 11), welche gleichzeitig einerseits durch eine erste Beschaltung einen Antennenbetrieb für elektromagnetische Strahlung im Hochfrequenzbereich zwischen etwa 300 Mhz und 3 GHz, andererseits durch eine zweite Beschaltung einen kapazitiven Spannungsteilerbetrieb im niederfrequenten Bereich bewirkt, getrennt voneinander zugänglich sind.

2. Meßsystem nach Anspruch 1,
**dadurch gekennzeichnet**, daß
jeweils an eine Meßsonde (3) mittels einer Meßleitung (4) ein Kondensator (5) angeschlossen ist, an dem die hochfrequenten Störsignale abnehmbar sind,
daß die Meßleitung (4) zwischen der Meßsonde (3) und dem Kondensator (5) über einen Tiefpaß (10, 11) mit dem Erdpotential verbunden ist und daß sowohl der Kondensator (5) als auch der Ausgang (12) des Tiefpasses (10, 11) mit einer Auswerteinrichtung (15) zur Auswertung der relativen Phasenlage der Störsignale zur Nutzspannung verbunden sind.

3. Meßsystem nach Anspruch 2,
**dadurch gekennzeichnet**, daß
dem Kondensator (5) eine weitere Filteranordnung (7) nachgeschaltet ist, die die Abnahme von Störsignalen in mehreren verschiedenen Frequenzbereichen ermöglicht.

4. Meßsystem nach Anspruch 2 oder einem der folgenden,
**dadurch gekennzeichnet**, daß
an dem Tiefpaß (10, 11) zusätzlich zu dem Nutzspannungssignal eingekoppelte höherfrequente Signalanteile von transienten Überspannungen mit gedämpfter Intensität abnehmbar sind.

5. Meßsystem nach Anspruch 4,
**dadurch gekennzeichnet**, daß
die Auswerteinrichtung (15) eine Prüfeinrichtung zur Prüfung des am Ausgang (12) des Tiefpasses (10, 13) anliegenden Signals auf höherfrequente Signalanteile der Nutzspannung oder daraus resultierende Überspannungen aufweist und daß die Prüfeinrichtung bewirkt, daß im Falle des Vorhandenseins höherfrequenter Signalanteile der Nutzspannung oder daraus resultierender Überspannungen keine Störung ausgewiesen wird.

## Claims

1. Measurement system for electrical faults in an enclosed high-voltage switching station (1, 2) which carries a useful voltage in the form of a low-frequency alternating voltage, comprising at least one measurement probe (3) in each case for each phase to couple out electromagnetic fault signals from the switching station (1, 2), and comprising an evaluation device (15) for determining the time correlation of the occurrence of the fault signals with reference to the period of the low-frequency useful voltage of the respective phase in which the fault signals occur, both the fault signals and the useful voltage being tapped off in each case for at least one phase by the same measurement probe (3) designed as measuring electrode without conductive coupling, characterized in that the fault signals and the useful voltage are accessible separately from one another at a filter arrangement (5, 10, 11) which simultaneously effects, on the one hand, through a first circuit an aerial mode for electromagnetic radiation in the high-frequency range between about 300 MHz and 3 GHz and, on the other hand, a capacitive voltage divider mode in the low-frequency range by means of a second circuit.

2. Measurement system according to Claim 1, characterized in that there is connected in each case to a measurement probe (3) by means of a measurement line (4) a capacitor (5) at which the high-frequency fault signals can be picked off, in that the measurement line (4) between the measurement probe (3) and the capacitor (5) is connected via a low-pass filter (10, 11) to earth potential and in that both the capacitor (5) and also the output (12) of the low-pass filter (10, 11) are connected to an evaluation device (15) for evaluating the relative phase position of the fault signals with respect to the useful voltage.

3. Measurement system according to Claim 2, characterized in that there is connected downstream of the capacitor (5) a further filter arrangement (7) which makes it possible to pick off the fault signals in a plurality of different frequency ranges.

4. Measurement system according to Claim 2 or one of the subsequent claims, characterized in that, in addition to the useful voltage signal, coupled-in higher-frequency signal components of transient overvoltages can be picked off with attenuated intensity at the low-pass filter (10, 11).

5. Measurement system according to Claim 4, characterized in that the evaluation device (15) has a test device for testing the signal present at the output (12) of the low-pass filter (10, 11) for higher-frequency signal components of the useful voltage or the overvoltages resulting therefrom and in that the test device effects the result that no fault is indicated if higher-frequency signal components of the useful voltage or overvoltages resulting therefrom are present.

## Revendications

1. Système de mesure des interférences électriques dans une installation de distribution électrique haute tension blindée (1, 2), qui conduit une tension utile sous forme de tension alternative à basse fréquence, comprenant respectivement au moins une sonde de mesure (3) pour chaque phase afin d'extraire des signaux parasites électro-magnétiques de l'installation distributrice (1, 2) et un dispositif d'évaluation (15) afin de déterminer l'association temporelle de l'apparition des signaux parasites par rapport à la période de la tension utile basse fréquence de la phase respective sur laquelle les signaux parasites apparaissent, aussi bien les signaux parasites que la tension utile étant prélevés pour au moins une phase respectivement par la même sonde de mesure (3) conçue comme une électrode de mesure sans couplage galvanique,
caractérisé par le fait que
les signaux parasites et la tension utile sont accessibles séparément au niveau d'un dispositif de filtrage (5, 10, 11), qui met en oeuvre simultanément d'une part, au moyen d'un premier montage, un fonctionnement en antenne pour un rayonnement électromagnétique dans le domaine haute fréquence entre environ 300 MHz et 3 GHz et d'autre part, au moyen d'un deuxième montage, un fonctionnement en diviseur de tension capacitif dans le domaine basse fréquence.

2. Système de mesure selon la revendication 1,
caractérisé par le fait que
il est raccordé respectivement à une sonde de mesure (3) au moyen d'une ligne de mesure (4) un condensateur (5) au niveau duquel les signaux parasites haute fréquence peuvent être prélevés,
la ligne de mesure (4) est reliée entre la sonde de mesure (3) et le condensateur (5) par l'intermédiaire d'un filtre passe-bas (10, 11) au potentiel de terre et le condensateur (5) et la sortie (12) du filtre passe-bas (10, 11) sont reliés à un dispositif d'évaluation (15) destiné à l'évaluation de la relation de phase des signaux parasites par rapport à la tension utile.

3. Système de mesure selon la revendication 2,
caractérisé par le fait que
il est branché du côté aval du condensateur (5) un autre dispositif de filtrage (7) qui permet le prélèvement de signaux parasites dans plusieurs domaines fréquentiels différents.

4. Système de mesure selon la revendication 2 ou selon l'une des suivantes,
caractérisé par le fait que,
outre le signal de tension utile, des composantes de signal haute fréquence introduites appartenant à des surtensions transitoires à intensité affaiblie peuvent être prélevées au niveau du filtre passe-bas (10, 11).

5. Système de mesure selon la revendication 4,
caractérisé par le fait que
le dispositif d'évaluation (15) comporte un dispositif de test destiné à tester le signal présent à la sortie (12) du filtre passe-bas (10, 13) pour détecter des composantes de signal haute fréquence de la tension utile ou des surtensions en résultant et que le dispositif de test est tel que, en présence de composantes de signal haute fréquence de la tension utile ou de surtensions en résultant, aucune interférence n'est signalée.
